# EUROPEAN PATENT APPLICATION

(11) **EP 4 576 472 A1**
(43) Date of publication of application: **25.06.2025**
(21) Application number: 23220007.1
(22) Date of filing: 22.12.2023
(51) Int. Cl.: H02J 3/00, C25B 15/02, G01R 19/25

(54) **COMPUTER-IMPLEMENTED METHOD FOR VERIFYING A GRID CODE COMPLIANCE OF LARGE-SCALE ELECTROLYSIS PLANTS**

(71) Applicant: Siemens Energy Global GmbH & Co. KG, 81739 München (DE)
(72) Inventor: Loku, Fisnik, 90768 Fürth (DE); Lukianov, Semen, 91058 Erlangen (DE); Schumann, Sven, 91452 Wilhermsdorf (DE)

(57) **Abstract**

A computer-implemented method 100 for verifying a grid code compliance of an electrolysis plant is provided, wherein the electrolysis plant comprises a plurality of essentially identical electrolysis systems connected in parallel to a same AC power grid. The method comprises determining 104 a model of the AC power grid and at least one grid compliance requirement, determining 106 a model of the electrolysis plant, and verifying 108 a grid code compliance of the electrolysis plant by performing a simulated grid compliance test with respect to the at least one grid compliance requirement, for the model of the electrolysis plant connected to the model of the AC power grid, wherein the step of determining 106 a model of the electrolysis plant comprises determining 110 a first set of parameter values characterizing a first electrolysis system of the plurality of essentially identical electrolysis systems and a scaling factor corresponding to a size of the plurality of essentially identical electrolysis systems, and determining 112 an aggregated set of parameter values characterizing the electrolysis plant as the first set of parameter values scaled depending on said scaling factor.

## Description

The present disclosure in general relates to the operability of electrolysis plants consisting of multiple electrolysis systems. More particularly, the present disclosure relates to a computer-implemented method for verifying a grid code compliance of an electrolysis plant. Further, the present disclosure relates to a computer program product, a computer-readable storage medium and a data carrier signal.

The number of installed electrolysis systems in existing transmission networks, i.e., connected to power grids, continuously increases, in particular due to an increasing demand for green hydrogen production, i.e., the production of hydrogen using renewable energy sources. In order to accelerate the green hydrogen production, the capacity of planned electrolysis system projects is in the Giga-Watt range. In order to set up such large-scale electrolysis plants, i.e., hydrogen production plants using electrolysis, i.e., a process of using electricity to split water into hydrogen and oxygen, multiple, e.g., several dozens or hundreds or even more, electrolyser systems are connected in parallel to an alternating current (AC) power grid and are potentially all operated at the same time.

Each of the electrolysis systems contains a set of, i.e., one or more, potentially many more, electrolyser units wherein the hydrogen generation takes place and which requires the supply of direct current (DC). The direct current used in an electrolysis system is generated by an electrical energy conversion arrangement connected to an AC power grid that in particular comprises a transformer system and a rectifier system which then provides the generated DC current to the set of electrolyser units. Such sets of electrolyser units constitute a high-power load.

For testing electrolysis systems in particular of such large-scale electrolysis plants, detailed electro-magnetic transient (EMT) and Root-Mean-Square simulation models may be applied. Furthermore, the used models should be able to represent an electrolysis plant in detail, as grid code requirements of the connected AC power grid must be fulfilled, for example regarding the power quality and the fault-ride-through capability at the point-of-connection (POC) of the electrolysis systems and the AC power grid.

An AC power grid requires any connected facility, such as electricity generating plants, consumers (such as electrolysis plants or electrolysis systems), or other connected networks to abide to its grid code, i.e., a technical specification which defines the parameters the connected facility, and therefore also energy conversion arrangements of an electrolysis system, has to meet to ensure safe, secure, economic and correct functioning of the electric system.

For simulation for testing purposes of electrolysis plants merely consisting of two electrolysis systems in parallel operation, detailed models can be delivered as two separate building blocks in different simulation environments, without posing significant constraints on the resulting required simulation time or processor resources. However, for systems consisting of several tens or hundreds of electrolysis systems in parallel, CPU resource demands and/or the necessary processing time required for the models to run individual system simulations can be very high, even such high that the simulation time requirements for the different simulation environments as specified by a corresponding grid operator of the AC power grid may be very difficult or impossible to meet with current CPU technologies.

Therefore, for such large-scale electrolysis plants, an aggregated model of the electrolysis systems can be used, with which the grid compliance tests for the electrolysis plant can be conducted.

As shown, for example, in PROMOTioN WP16, "Deliverable 16.3: Overview of the conducted tests, the results and the associated analyses with respect to the research questions and analyses within WP3", February 2020, behaviour of electrolysis systems can be aggregated and described by utilizing an interface model between the electrolysis systems and the adjacent AC network, i.e., the connected AC power grid. Such an interface model is based on current and voltage measurements at the Point-of-Connection (POC) and utilises controllable current and voltage sources. The working principle of such an interface model can be the following: a voltage or current is measured at the electrolysis system inputs. These measured values are then scaled up to represent the equivalent number of the electrolysis systems needed to be aggregated. These scaled up values are then provided as a reference signal to the controllable current or voltage source connected to the AC network, i.e., the AC power grid. At the AC network side, the voltage or the current signals are measured, scaled down and provided as reference signals to the controllable voltage or current source connected at the inputs of the electrolysis system. The measurement and the application of the signals as reference values to the controllable sources requires at least a delay of one simulation time step. In other words, the described approach means that a connection point between the simulated electrolysis system and the adjacent AC network is represented by controllable current and voltage sources and for the same connection point an artificial time delay is introduced, which, however, is not present in the corresponding real system.

However, depending on the overall network situation (e.g., transient phenomena, operation point, etc.), this additionally introduced time delay may lead to instabilities in the simulated system, which may not be present in the corresponding real systems.

This is a known issue in Power-Hardware-in-the-Loop applications, as they apply similar interface algorithms, such as the Ideal Transformer Method (ITM, same method as described above for electrolysis system applications), Damping Impedance Method (DIM), Transmission Line Method (TLM), etc., cf. Loku et al., "Utilization of the Impedance-based Stability Criterion for Stability Assessment of PHiL Interface Algorithms", 2022 IEEE 13th International Symposium on Power Electronics for Distributed Generation Systems (PEDG), Kiel, Germany, 2022. As a result, based on such an approach the performance of the system operation might be considered worse than the actual performance of a corresponding real system operation, and might lead, e.g., to unnecessary oversizing of equipment and unnecessary costs.

It is an objective of the present invention to provide an alternative approach to testing large scale electrolysis plants comprising multiple electrolysis systems requiring less processor time and without potentially creating artificial instabilities.

This objective is solved by a computer-implemented method for verifying a grid code compliance of an electrolysis plant as stated in claim 1 and a corresponding computer program product, a computer readable storage medium and a data carrier signal as stated in claims 9, 10 and 11, respectively. Advantageous additional embodiments of the invention are disclosed in the respective dependent claims.

According to a first aspect of the invention, a computer-implemented method for verifying a grid code compliance of an electrolysis plant is provided, wherein the electrolysis plant comprises a plurality of essentially identical electrolysis systems connected in parallel to a same AC power grid. The method comprises determining a model of the AC power grid and at least one grid compliance requirement, determining a model of the electrolysis plant, and verifying a grid code compliance of the electrolysis plant by performing a simulated grid compliance test with respect to the at least one grid compliance requirement, for the model of the electrolysis plant connected to the model of the AC power grid. The step of determining a model of the electrolysis plant comprises determining a first set of parameter values characterizing a first electrolysis system of the plurality of essentially identical electrolysis systems and a scaling factor corresponding to a size of the plurality of essentially identical electrolysis systems. And the step of determining a model of the electrolysis plant further comprises determining an aggregated set of parameter values characterizing the electrolysis plant as the first set of parameter values scaled depending on said scaling factor.

Essentially identical electrolysis systems are electrolysis systems that at least can be considered identical in terms of their electrical behaviour in the context of the grid code compliance test to be carried out.

The term "determining a model" can, e.g., refer to loading data that defines the model (i.e., an equivalent model, simulation model) from a memory or other data source.

The size of a plurality of essentially identical electrolysis systems is identical to the number of electrolysis systems constituting said plurality.

The described method does not include any interface algorithm (and thereby avoids artificial instability issues) to represent the behaviour of an electrolysis plant as the cumulative or aggregated behaviour of the parallel electrolysis systems the electrolysis plant consists of. Instead, the essentially identical electrolysis systems connected in parallel are described by a single one of the electrolysis systems having its set of parameter values that define its behaviour adjusted to define the behaviour of an aggregated electrolysis system that represents all parallel electrolysis systems, i.e., the electrolysis plant.

In a first example embodiment, the first set of parameter values characterizes the first electrolysis system as an electrical impedance. In good approximation concerning its energy consumption, an electrolysis system can be represented as a high-power load, by an electrical impedance.

In a second example embodiment, the first set of parameter values characterizes the first electrolysis system as a first energy conversion arrangement connected to a first set of electrolyser units.

In a more detailed example embodiment of the second example, the first energy conversion arrangement comprises at least a first transformer system having a primary side connected to the AC power grid and a secondary side connected to a first rectifier system, i.e., to an AC to DC converter system. Here, the scaling can be applied directly to the main building blocks of the first electrolysis system, i.e., the transformer system, the rectifier system and the electrolyser units to convert a model for the first electrolysis system into an aggregated model representing all parallel electrolysis systems of the electrolysis plant.

In an example embodiment, the aggregated set of parameter values comprises a power rating of the first transformer system multiplied by the scaling factor, whereas for the aggregated set of parameter values the primary side voltage and the secondary side voltage remain unchanged, i.e., the values of the first transformer system. In other words, the transformer of the first electrolysis system is scaled up by directly multiplying the power rating of the first transformer system with the scaling factor, i.e., the number of parallel electrolysis systems of the electrolysis plant. The primary side voltage, i.e., the input voltage of the transformer system, stays the same as for a single electrolysis system, as generally all electrolysis systems of the electrolysis plant are connected to the same AC power grid. Furthermore, the secondary-side voltage rating remains unchanged as well.

Other parameters of the transformer system, such as the positive sequence leakage reactance, no-load losses, copper losses, or saturation parameters, remain unchanged, i.e., unscaled, as they are provided in per-unit values. The corresponding scaling up of the transformer power rating and unchanged voltage ratings on the primary- or the secondary-side of the transformer lead to corresponding scaling up of the other parameters, such as the transformer losses, which will directly correspond to the overall transformer losses of the electrolysis systems connected in parallel.

In a further example embodiment, the aggregated set of parameter values (additionally) comprises a value of DC current provided to the first set of electrolyser units of the first transformer system multiplied by the scaling factor. Here, the VI-curve characteristic of the electrolysis units is adjusted by considering the number of the electrolysis systems connected in parallel in such a way that for the same input DC voltage at the electrolyser units of the aggregated electrolysis system, i.e. the electrolysis plant, as for a single electrolysis system, the resulting DC current is n times higher than the DC current for a single electrolysis system, with n representing the number of the electrolysis systems to connected in parallel, i.e., the scaling factor. Furthermore, considering that a control system may operate in per unit base, the per unitization of measured signals required for control is done considering the base values of a single array multiplied by the number of parallel electrolysis systems.

In a further example embodiment, the first rectifier system (additionally) comprises a set of first rectifier units and the aggregated set of parameter values comprises values of input current to the set of first rectifier units multiplied by the scaling factor and values of slope resistance of the set of first rectifier units divided by the scaling factor. Considering here that the input and the output voltages of the rectifier system of the aggregated electrolysis system do not change compared to those of the first electrolysis system, but the input current to the rectifiers of the rectifier system of the aggregated electrolysis system, i.e., of the electrolysis plant, is increased by multiplication with the scaling factor, the slope resistance of the rectifier units of the aggregated electrolysis system is accordingly adjusted, i.e., the slope resistance of the first electrolysis system is divided by the number of parallel electrolysis systems, i.e., the scaling factor.

In an embodiment, the at least one grid code requirement comprises a power quality or a fault-ride-through capability. Power quality is the degree to which the voltage, frequency, and waveform of an AC power grid fulfil a corresponding specification. Power quality describes electrical power that drives an electrical load and the ability of the connected load to function properly. Electric power can be of poor quality in many ways, wherein the power quality can be measured using (combinations of) several parameters such as severity of harmonics in the AC waveform of the power grid and transient voltages and currents and variations in voltage magnitude and continuity of service (e.g., blackouts caused by voltages below or above a threshold). Fault-ride-through capability refers to the capability to stay connected in short periods of lower voltage. Performing simulated grid code compliance tests for example allows to check, if an electrolysis plant desired by a customer can be safely connected and operated with an AC power grid provided or available to the customer (e.g., an island grid). For example, the amount and influence of harmonics sent to the grid may be tested in advance in order to decide whether or not a (potentially expensive) frequency filter system will be required to keep the planned network operational.

According to a second aspect of the invention, a computer program product comprises code portions that, when executed by a programmable apparatus, enable the programmable apparatus to carry out steps of a method according to the first aspect of the invention. In other words, the computer program product comprises code portions that, when executed on the programmable apparatus, enable the programmable apparatus to carry out a method according to an embodiment of the invention. A programmable apparatus is in particular a computer and comprises a processor and a memory, wherein the processor refers to any data processing unit such as a central processing unit (CPU), microprocessor or microcontroller. The computer program product corresponds to a computer program, at least including software code portions for performing steps of the method.

Further, according to a third aspect of the invention, a computer readable storage medium is provided, having stored therein a computer program product according to the second aspect of the invention. And according to a fourth aspect of the invention, a data carrier signal is provided that carries a computer program product according to the second aspect of the invention. The computer program product may be provided on a computer readable storage medium, i.e., a data carrier, such as a CD, DVD, memory card or other storage medium, in particular a non-volatile storage medium, stored with data that is loadable in a memory of the programmable apparatus, wherein the data represents the computer program. As another example, the data carrier may further be a data connection, such as a telephone cable or data cable or a wireless connection, and the computer program product may be represented as data carrier signal transmitted via the data carrier.

While not explicitly described, the presented embodiments may be employed in any combination or sub-combination.

The properties, features and advantages of the invention described above, and the manner in which they are achieved, will become clearer and more clearly understood in connection with the following description of the exemplary embodiments, which are explained in more detail in connection with the drawings, wherein:
- Fig. 1: schematically illustrates an example of a computer-implemented method for verifying a grid code compliance of an electrolysis plant according to an embodiment of the invention;
- Fig. 2: schematically illustrates an example of an equivalent circuit diagram of a first model of an electrolysis plant using a plurality of electrolysis systems connected to an AC power grid;
- Fig. 3: schematically illustrates an example of an equivalent circuit diagram of a second model of an electrolysis plant using an aggregated electrolysis system connected to an AC power grid; and
- Fig. 4: schematically illustrates an example of an equivalent circuit diagram of another model of an electrolysis system.

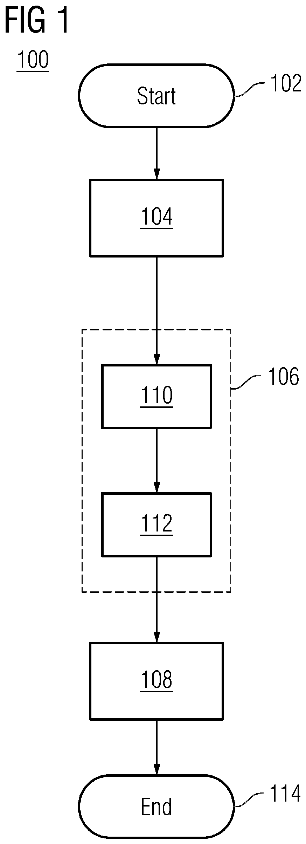

In Fig. 1, an example of a computer-implemented method 100 for verifying a grid code compliance of an electrolysis plant according to an embodiment of the invention is schematically shown, wherein the electrolysis plant comprises a plurality of essentially identical electrolysis systems connected in parallel to a same AC power grid. The computer-implemented method 100 starts 102 with an initialization that includes loading program code of a computer program product comprising instructions for a processor of the computer to carry out steps of the method 100 from a computer readable storage medium into a memory of the computer. In a first step of the method, a model of the AC power grid and at least one grid compliance requirement are determined 104. The model describes an AC power source that exhibits the parameters and characteristics of the available AC power grid. The at least one grid code compliance requirement for testing the electrolysis plant to be connected for example comprises a power quality or a fault-ride-through capability of the electrical network consisting at least of the AC power grid and the connected electrolysis plant.

In a next step, a model of the electrolysis plant is determined 106, and in a further step of the method 100, a grid code compliance of the electrolysis plant is verified 108 by performing a simulated grid compliance test with respect to the at least one grid compliance requirement, for the model of the electrolysis plant connected to the model of the AC power grid, wherein the actual grid code compliance test is carried out, e.g., by varying parameters of the AC power grid and verifying if the network response fulfils the selected grid code requirement or requirements to be tested. The method ends 114 after the verification. However, the method may return to start 102 in order perform further compliance tests, e.g., using different parameter sets and/or for verifying compliance with other grid code requirements.

In the shown embodiment, the method step of determining 106 a model of the electrolysis plant comprises determining 110 a first set of parameter values characterizing a first electrolysis system of the plurality of essentially identical electrolysis systems and a scaling factor corresponding to a size of the plurality of essentially identical electrolysis systems. Depending on the chosen model of the first electrolysis system, the set of parameter values differs. Since the electrolysis plant consists of essentially identical parallel electrolysis systems, any of the electrolysis systems may be chosen as the first electrolysis system.

According to the shown embodiment, the step of determining 106 a model of the electrolysis plant further comprises determining 112 an aggregated set of parameter values characterizing the electrolysis plant as the first set of parameter values scaled depending on said scaling factor. In other words, the electrolysis plant to be tested can then be described solely by the first electrolysis system adjusted by using the aggregated set of parameter values instead of the first set of parameter values.

The first set of parameter values may, for example, characterize the first electrolysis system as an electrical impedance. In a more detailed example, the first set of parameter values characterizes the first electrolysis system as a first energy conversion arrangement connected to a first set of electrolyser units, wherein the first energy conversion arrangement comprises at least a first transformer system having a primary side connected to the AC power grid and a secondary side connected to a first rectifier system. In an embodiment, determining the aggregated set of parameter values may comprise determining a power rating of the first transformer system (contained in the set of parameter values of the first electrolysis system) multiplied by the scaling factor. Further, the aggregated set of parameter values may comprise a value of DC current provided to the first set of electrolyser units of the first transformer system multiplied by the scaling factor. And the first rectifier system may comprise a set of first rectifier units and the aggregated set of parameter values can then be determined as comprising values of input current to the set of first rectifier units multiplied by the scaling factor and values of slope resistance of the set of first rectifier units divided by the scaling factor.

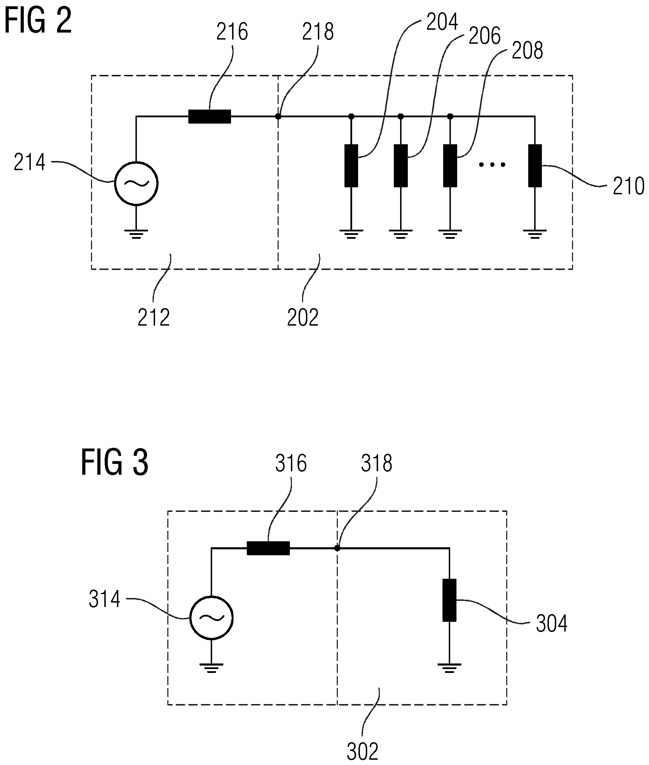

In Fig. 2, an example of an equivalent circuit diagram of a first model of an electrolysis plant 202 using a plurality of electrolysis systems 204, 206, 208, 210 connected to an AC power grid 212 is schematically shown. In the shown example, the model of the AC power grid 212 is represented by the shown AC power source 214 and an impedance 216. The model of the electrolysis plant 202 consists of the plurality of electrolysis systems 204, 206, 208, 210 connected in parallel to the AC power grid 212 via a Point-of-Connection (POC) 218. In the shown example, the essentially identical electrolysis systems 204, 206, 208, 210 are represented by impedances. One of the electrolysis systems 204, 206, 208, 210 is considered the first electrolysis system 204.

In Fig. 3, an example of an equivalent circuit diagram of a second model of an electrolysis plant 302 using an aggregated electrolysis system 304 connected to an AC power grid 312 via a Point-of Connection (POC) 318 is schematically shown. In the shown example, the model of the AC power grid 312 is represented by the shown AC power source 314 and an impedance 316. The model of the electrolysis plant 302 corresponds to the model of the electrolysis plant 202 shown in Fig. 2, but consists of the aggregated electrolysis system 304 that may correspond to the first electrolysis system 204 shown in Fig. 2, but adapted by adjusted parameters to represent the whole plurality of electrolysis systems 204, 206, 208, 210 shown in Fig. 2. In the shown example, it is represented by an impedance. If, for example, the AC power grid 312 is equivalent to the AC power grid 212 shown in Fig. 2 and the aggregated electrolysis system 304 corresponds to the plurality of electrolysis systems 204, 206, 208, 210 connected in parallel to the AC power grid 212, the voltage at the impedance of the aggregated electrolysis system 304 and at the impedances of the plurality of electrolysis systems 204, 206, 208, 210 remains the same, whereas current through each of the impedances of, for example, 10 kA will be represented by a current of 40 kA at the impedance of the aggregated electrolysis system 304 in Fig. 3.

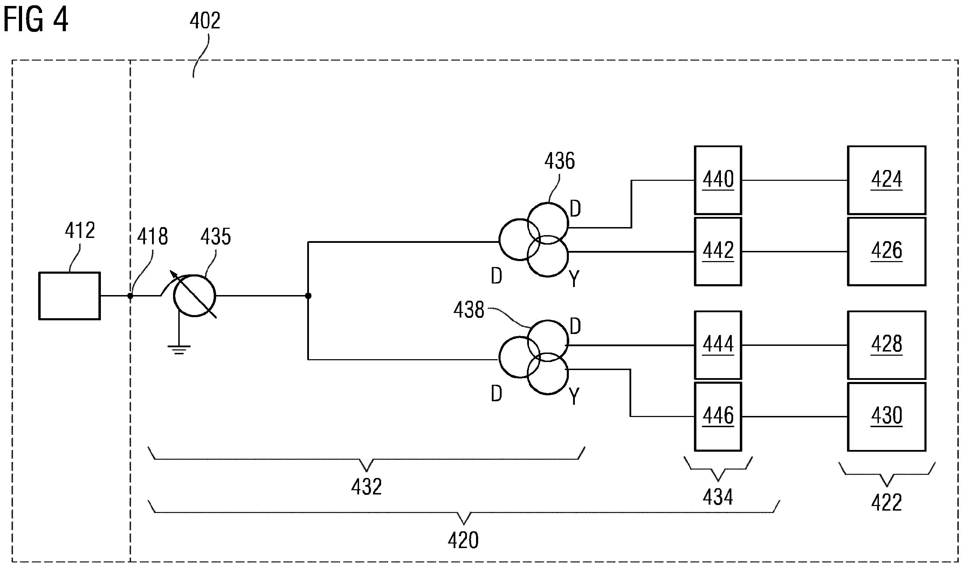

In Fig. 4, an example of an equivalent circuit diagram of another model of an electrolysis system 402 is schematically shown. The electrolysis system 402 may be an aggregated electrolysis system representing a plurality of parallel electrolysis systems of an electrolysis plant. The shown model of an electrolysis system 402 is connected via a Point-of-Connection (POC) 418 to a Thevenin equivalent AC power source 412 representing an AC power grid. The model of the electrolysis system 402 comprises an energy conversion arrangement 420 connected to a set 422 of electrolyser units 424, 426, 428,430 which may, for example, represent Proton Exchange Membrane (PEM) electrolyser units. The shown model of an energy conversion arrangement 420 contains a transformer system 432 connected to the POC 418 and to a rectifier system 434 which provides DC current to the set 422 of electrolyser units 424, 426, 428, 430. In the shown example, the transformer system 432 comprises an autotransformer 435 (including a tap changer) connected to two transformer units 436, 438 which may represent a +7.5° phase-shifting transformer unit and a -7.5° phase-shifting transformer unit, and the shown rectifier system 434 is a 24-pulse thyristor bridge rectifier system that comprises four 6-pulse thyristor bridge rectifier units 440, 442, 444, 446.

Those skilled in the art will recognize that the boundaries between blocks are merely illustrative and that alternative embodiments may merge blocks or impose an alternative composition of functionality upon various blocks. It should be noted that, depending on the embodiment, method steps, although described and illustrated according to certain sequence or order of steps, may at least partly be carried out in a different order or simultaneously. Other steps may be added and certain steps described here may be left out.

Although the invention has been illustrated and described in detail by the shown preferred embodiments, the invention is not limited by the disclosed examples and other variations can be derived therefrom by those skilled in the art without departing from the scope of the invention.

In summary, a computer-implemented method 100 for verifying a grid code compliance of an electrolysis plant is provided, wherein the electrolysis plant comprises a plurality of essentially identical electrolysis systems connected in parallel to a same AC power grid. The method comprises determining 104 a model of the AC power grid and at least one grid compliance requirement, determining 106 a model of the electrolysis plant, and verifying 108 a grid code compliance of the electrolysis plant by performing a simulated grid compliance test with respect to the at least one grid compliance requirement, for the model of the electrolysis plant connected to the model of the AC power grid, wherein the step of determining 106 a model of the electrolysis plant comprises determining 110 a first set of parameter values characterizing a first electrolysis system of the plurality of essentially identical electrolysis systems and a scaling factor corresponding to a size of the plurality of essentially identical electrolysis systems, and determining 112 an aggregated set of parameter values characterizing the electrolysis plant as the first set of parameter values scaled depending on said scaling factor.

Further, a computer program product, a computer readable storage medium and a data carrier signal are provided.

## Claims

1. Computer-implemented method (100) for verifying a grid code compliance of an electrolysis plant, wherein
the electrolysis plant comprises a plurality of essentially identical electrolysis systems connected in parallel to a same AC power grid, the method comprises
determining (104) a model of the AC power grid and at least one grid compliance requirement;
determining (106) a model of the electrolysis plant; and
verifying (108) a grid code compliance of the electrolysis plant by performing a simulated grid compliance test with respect to the at least one grid compliance requirement, for the model of the electrolysis plant connected to the model of the AC power grid; **characterized in that** the step of determining a model of the electrolysis plant comprises
determining (110) a first set of parameter values characterizing a first electrolysis system of the plurality of essentially identical electrolysis systems and a scaling factor corresponding to a size of the plurality of essentially identical electrolysis systems; and
determining (112) an aggregated set of parameter values characterizing the electrolysis plant as the first set of parameter values scaled depending on said scaling factor.

2. The computer-implemented method as claimed in claim 1, wherein the first set of parameter values characterizes the first electrolysis system as an electrical impedance.

3. The computer-implemented method as claimed in claim 1, wherein the first set of parameter values characterizes the first electrolysis system as a first energy conversion arrangement connected to a first set of electrolyser units.

4. The computer-implemented method as claimed in claim 3, wherein the first energy conversion arrangement comprises at least a first transformer system having a primary side connected to the AC power grid and a secondary side connected to a first rectifier system.

5. The computer-implemented method as claimed in claim 4, wherein the aggregated set of parameter values comprises a power rating of the first transformer system multiplied by the scaling factor.

6. The computer-implemented method as claimed in claim 4 or claim 5, wherein the aggregated set of parameter values comprises a value of DC current provided to the first set of electrolyser units of the first transformer system multiplied by the scaling factor.

7. The computer-implemented method as claimed in any of claims 4 to 6, wherein the first rectifier system comprises a set of first rectifier units and the aggregated set of parameter values comprises values of input current to the set of first rectifier units multiplied by the scaling factor and values of slope resistance of the set of first rectifier units divided by the scaling factor.

8. The computer-implemented method as claimed in any of the preceding claims, wherein the at least one grid code requirement comprises a power quality or a fault-ride-through capability.

9. Computer program product, comprising code portions that, when executed by a programmable apparatus, enable the programmable apparatus to carry out steps of a method (100) according to any of the claims 1 to 8.

10. Computer readable storage medium, having stored there-on a computer program product as claimed in claim 9.

11. Data carrier signal carrying the computer program product as claimed in claim 9.
